# EUROPEAN PATENT APPLICATION

(11) **EP 4 092 720 A1**
(43) Date of publication of application: **23.11.2022**
(21) Application number: 21174873.6
(22) Date of filing: 20.05.2021
(51) Int. Cl.: H01L 21/48, H01L 23/367, H01L 23/40, H01L 23/433

(54) **HEAT SINK**

(71) Applicant: Aptiv Technologies Limited, St. Michael (BB)
(72) Inventor: Rademacher, Falk, 51647 Gummersbach (DE); Bretschneider, Alf, 51766 Engelskirchen-Ründeroth (DE); Reinhold, Peter, 51647 Gummersbach (DE)
(74) Representative: Vigand, Philippe

(57) **Abstract**

A heat sink (10) comprising a body (11) non-adjustably mountable on a support (20) provided with at least one element (25) to be cooled, characterized in that said body (11) comprises at least one insert (15) that is adjustably fitted therein so that an insert contact surface (16) comes into contact with the element (25) to be cooled.

## Description

### TECHNICAL FIELD

The present disclosure relates to the field of electronics, more particularly to printed circuit board or electronic devices such as electronic control unit (ECU) that can typically be found in the automotive field.

More specifically, the present disclosure concerns a heat sink that any electronic circuit board or device could be provided with, as well as a printed circuit board acting as a support for such a heat sink and a vehicle comprising such a printed circuit board.

### BACKGROUND

Most electronic components such as integrated circuits (IC) with high power dissipation generate thermal energy. Heat generated by an integrated circuit must be removed to the ambient environment to maintain the junction temperature of the component within safe operating limits. If that energy is not transferred away from the circuits, it would cause defects on its own source and the integrated circuit may be damaged, destroyed or shutdown by itself.

To prevent such issues, heat sinks are connected to integrated circuits and transfer thermal energy to movable medium, mostly gaseous medium like air or fluid medium like water or oil. These mediums transfer the thermal energy to colder areas where the heat can finally be exchanged out of the electronic circuits or device to be cooled.

Typically, a heat sink arranged onto a printed circuit board is provided with a body having columns acting as legs for securing the heat sink to the printed circuit board, especially at least over the heating source of the board which is generally constituted by one or more processors, chips or chipsets. Located at the back of the surface facing the printed circuit board, the body is provided with a plurality of protruding elements that play the role of heat exchangers. Instead or in addition, the body may also be provided with cooling channels in order to help extract heat from the heating source.

In order to be enough efficient, the body of the heat sink further includes pads, blocks or contact members that each of which aims to come as close as possible to the heat source. However, due to several reasons, the pads do not properly reach the upper surface of each chip or integrated circuit to be cooled. The aforementioned reasons mainly result from assembly tolerances between the heat sink and the printed circuit board. In addition, the package surface of the integrated circuit has sometimes planarity deficiencies that give the surface concave, convex or even twisted shapes. For any of these reasons, there is often a gap between the upper package surface of the integrated circuits and the lower contact surfaces or pads of the heat sink. Since air is essentially a thermal insulator, any interstitial air gap should be eliminated given that it represents a significant resistance to heat flow.

To efficiently remove heat from the heating source, there is a need to fill each gap using a gap filler also referred to as thermal interface material (TIM). A large variety of material types having a greater thermal conductivity than the air has been developed as thermal interface materials.

From the foregoing, one can note that the thermal efficiency of a heat sink is strongly dependent on the gap between the upper package surface of the integrated circuit and the lower surface of the heat sink pad that is intended to come into contact with the heating element. Indeed, the smaller the gap, the higher the thermal efficiency.

Known heat sinks in automotive industry, especially in vehicle electronic control units (ECUs), are generally integrated in the enclosure of the ECU. Such heat sinks further have to fixedly hold the printed circuit board of the ECU. Accordingly, their function is thus double, in the sense that they have to cool the heating element(s) of the printed circuit board and to secure the latter within the ECU enclosure. However, the designs of such heat sinks do not provide optimum heat dissipation, mainly due to the tolerance stack at the gap which is filled by the thermal interface material.

In other technical field, some heat sinks use compression spring connection means located at the four corners of the heat sink body for securing the latter to the printed circuit board. Such a design allows to adjust the distance between the base of the body and the upper package surface of the integrated circuit of the board. However, to obtain a correct adjustment, it is necessary to adjust the four screws that are provided with the connection means and allow to compress or release the helical springs of the connections. Such an adjustment is quite long to implement, especially due to the fact that it is particularly difficult to make the base of the heat sink parallel to the upper package surface of the integrated circuit. In addition, such a design does not allow an integration into an ECU enclosure provided with a liquid or air cooling channel due to the movability of the body. Furthermore, the connection means are likely to go out of adjustment, especially when the printed circuit board or the ECU enclosure is subject to vibrations or shocks, which is the case in certain fields, in particular in the automotive industry. Finally, the aforementioned design is not suitable when the printed circuit board is provided with several heating elements having different heights protruding above the upper plane of the printed circuit board. Indeed, in such a case, only the highest heating element may come into contact with the base of the heat sink in an optimal way.

Document US6396692B1 discloses an ECU comprising a cooling module provided with a fluid channel therein. The heat generated by the electronic components of the ECU is convectively transferred to the cooling module.

Document KR101735736B1 relates to an ECU of a vehicle provided with at least one heating element and a housing into which the ECU is inserted. A heat sink portion is installed to face one side of the housing and covering the other side. The heat sink is provided with a plurality of heat radiation pins which are arranged in parallel in a direction which is the height direction of the housing.

Document CN211702650U relates to an automotive ECU controller shell provided with a vibration damper. Indeed, damping pads are arranged at the four corners of the shell and are provided with mounting holes. The heat dissipation performances of the controller housing are improved compared with those of a conventional controller housing.

However, as the devices or systems provided in the background art are unable to solve the previously cited issues, there is a need for improving existing disclosures in order to at least partially overcome the aforementioned drawbacks. In particular, it is suitable to propose a new approach that is more efficient, among others by ensuring the smallest gap for the thermal interface material.

### SUMMARY OF THE DISCLOSURE

To address such a concern, the present disclosure provides a heat sink comprising a body non-adjustably mountable on a support provided with at least one element to be cooled. The body comprises at least one insert that is adjustably fitted therein, so that an insert contact surface comes into contact with the element to be cooled.

Due to the features of the above heat sink, the insert can advantageously be adjusted, with respect to the immovable body attached to the support, in such a way as to come in contact or almost contact with the element to be cooled. Accordingly, any gap resulting from mounting tolerances between the heat sink and the support on which it is attached can be compensated for by the adjustment function of the insert in relation to the body of the heat sink. As a result, the present heat sink provides an optimum dissipation of the heat generated by the heating element(s) of the support to be cooled regardless of certain dimensional flaws that may typically result from machining, mounting and/or assembly tolerances.

In addition, since the body of the heat sink of the present disclosure remains immovable relative to the support or printed circuit board on which it is secured, it is fully designed to be integrated into an enclosure, such as an ECU housing, which may further be provided with a liquid or air cooling channel.

Preferably, the present heat sink is adjustable along an axis of movement that is orthogonal to an element contact surface of the element to be cooled.

In one embodiment, the insert is adjustably fitted into the body by means of a first threaded part of the insert which engages a second threaded part of the body.

Preferably, the first threaded part is located at a periphery of the insert and the second threaded part is a threaded hole arranged within the body.

According to one embodiment, the insert is adjustably fitted into the body by means of a push-fit inter-engagement.

Preferably, the inter-engagement between the body and the insert involves a periphery of the insert in its entirety.

In one embodiment, the heat sink further comprises a sealing between the insert and the body.

Depending on the embodiment, the sealing may be a thread sealant or a thread lock.

In one embodiment, the sealing is an O-ring which preferably protrudes at a periphery of the insert.

According to another embodiment, the insert is adjustably fitted into the body for coming into contact with the element to be cooled via a first layer of a thermal interface material.

In one embodiment, the insert further comprises a gripping means for helping the insert to be adjusted within the body.

In another embodiment, the insert further comprises a plurality of heat exchanger elements arranged on a free surface opposite to the insert contact surface.

According to one embodiment, the body further comprises, on a body free surface opposite to the element to be cooled, at least one of a plurality of heat exchanger elements and at least one cooling channel for transporting a fluid.

The present disclosure further relates to a printed circuit board as a support non-adjustably mounted on a heat sink according to any of its embodiments or according to any possible combination of its embodiments.

The present disclosure also relates to a vehicle comprising the aforementioned printed circuit board.

Other embodiments and advantages will be disclosed hereafter in the detailed description.

### BRIEF DESCRIPTION OF THE DRAWINGS

The disclosure and the embodiments provided in the present description should be taken as non-limitative examples and will be better understood with reference to the attached figures in which:
Fig. 1 is a perspective representation of one embodiment of the heat sink of the present disclosure mounted on a support and depicted according to a partial vertical section,
Fig. 2 is an elevation view of another embodiment of the heat sink of the present disclosure in which only the body has been depicted in vertical section,
Fig. 3 is a first variant of the embodiment shown in Fig. 1,
Fig. 4 is a second variant of the embodiment shown in Fig. 1, and
Fig. 5 provides another embodiment of the present heat sink.

### DETAILED DESCRIPTION

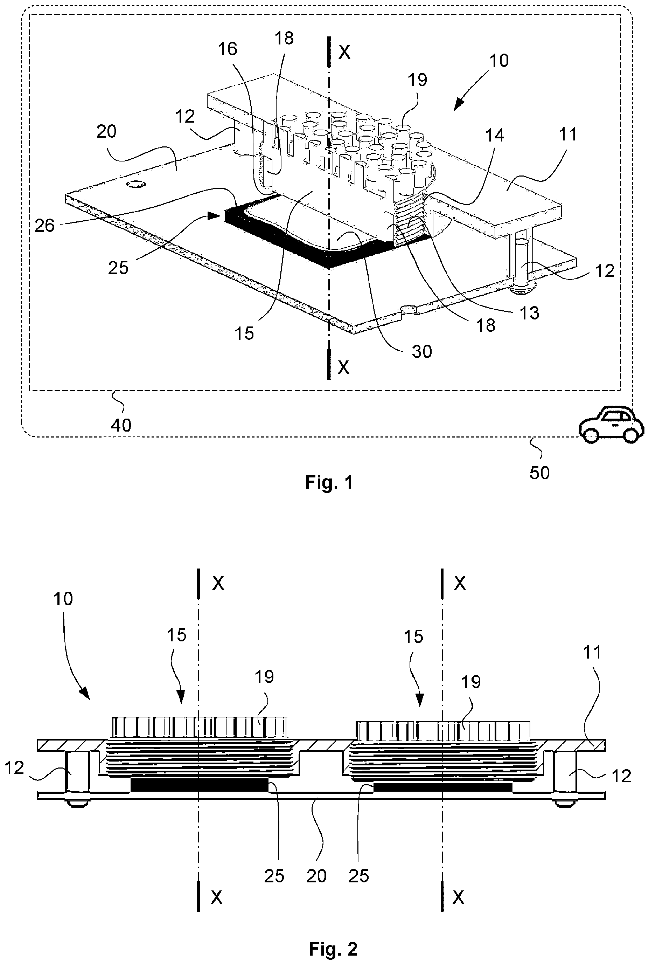

Fig. 1 depicts a heat sink 10, namely a heat dissipater or a heat spreader. The heat sink 10 is mounted on a support 20 provided with an element 25 to be cooled. The element 25 to be cooled may also be regarded as a heating element 25 which is preferably immovable with respect to its support 20. The element 25 to be cooled may typically be a chip, a chipset, an integrated circuit (IC), a central processing unit (CPU) or any other semiconductor. It should be noted that the element 25 to be cooled is not limited to an electronic component but may also be an electrical element such as a transformer for example. The support 20 may be a plate or any element to be assembled to the heat sink 10. Preferably, the support 20 is a printed circuit board (PCB). It may relate to a PCB of an electronic control unit (ECU), more particularly a PCB belonging to a vehicle's ECU for instance.

It should be noted that depending on the relative sizes of the heat sink 10 and the support 20, one can consider that the heat sink 10 is supported by the support 20, especially if the support 20 is larger than the heat sink 10, or that the support 20 is supported by the heat sink 10, e.g. in the case where the support 20 is smaller than the heat sink 10. The two aforementioned cases should be considered as equivalent in the present disclosure given that the main role of the support 20 is to be assembled to the heat sink 10 in order to cool the heating element(s) 25 that the support 20 includes. The aforementioned support may also be considered to have been so named in reference to the at least one element 25 to be cooled that it carries.

The illustration of Fig. 1, as well as those in the other figures, is a schematic representation in which the PCB, namely the carrier or support 20, and its IC have been simplified for clarity purposes. To better show the assembly, Fig. 1 has been provided in a perspective view in which the heat sink 10 is shown in a partial vertical cross section.

The embodiment depicted in Fig. 1 further shows a thermal interface material 30 that has been arranged on the upper package surface of the element 25 to be cooled. The upper package surface of the element 25 will be also referred to as the element contact surface 26 in the present disclosure. The thermal interface material 30 is fully optional and can be used e.g. to compensate certain flatness defaults of the element contact surface 26 or a possible lack of parallelism between the heat sink 10 and the element contact surface 26.

As shown in Fig. 1, the heat sink 10 includes a body 11 that is mountable on the support 20. More specifically, the body 11 is non-adjustably mounted on the support 20. To this end, it may have several legs 12 that allow to secure it to the support 20, for example using fastening screws 22 that connect the body 11 to the support 20 through the legs 12 which are each provided with a treaded hole. Other attachment means such as rivets or interlocking means could of course be used.

According to the present disclosure, the body 11 has at least one insert 15, or spread insert, that is adjustably fitted to the body 11 so that an insert contact surface 16 can come into contact with the element 25 to be cooled. Therefore, the insert 15 is adjustable within the body 11, relative to the latter. Since the body 11 is fixedly mounted on the support 20, it also means that the insert 15 is adjustable relative to the support 20. More specifically, the insert 20 is adjustable along an axis of movement X-X that is perpendicular to the element contact surface 26 of the element 25 to be cooled.

Due to the features of the present heat sink 10, it becomes possible to adjust the insert 20, so that at least a part of the heat sink 10 can be moved against or as close as possible towards the element contact surface 26 of the element 25 to be cooled. Such a design allows to ensure the smallest gap, or even no gap, between the element 25 to be cooled and the heat sink 10. Accordingly, the thermal efficiency of the heat sink 10 can be increased.

Furthermore, the present heat sink 10 is not limited to have a single insert 15 but may include several inserts 15 which can be each adjusted independently from the others, as depicted in the example of Fig. 2. Therefore, if the same support 20 has several elements 25 to be cooled which have elements contact surfaces protruding at different heights above the support 20, the present heat sink 10 has the ability to adapt to each of the elements 25 of the support 20. In other words, the heat sink 10 of the present disclosure is particularly efficient, not only with a support 20 comprising a single element 25 to be cooled, but also with a support 20 comprising a plurality of elements 25, even if those or a part of them protrude at different levels above the support 20, as shown in Fig. 2.

Moreover, the present heat sink 10 advantageously does not have any elastic member for connecting the body 11 to the support 20, so that no relative movement can be observed between them. Accordingly, the heat sink 10 is especially convenient for integration into an enclosure, such as a housing for an ECU which may preferably be provided with a fluid (liquid or gas) cooling channel. Besides, the rigid attachment of the present heat sink 10 to its support 20 advantageously provides a monolithic element that is non sensitive to vibrations. Consequently, the heat sink 10 also appears particularly well designed for mounting on a vehicle or any device subject to movements or vibrations.

Although the insert 15 is preferably adjustable along an axis of movement X-X that is orthogonal to the support 20, more specifically perpendicular to the element contact surface 26 of the element 25 of the support 20, it should be noted that the insert 15 could be adjustable according to a slanted axis of movement, for example using inclined sliding grooves arranged within the body 11. In such a case, the insert 15 may be provided with protrusions intended to engage the grooves of the body 11. A dovetail profile assembly (inclined e.g. at an acute angle relative to the planar surface of the support 20) may be used for example to move the insert 15 into the body 11, until the insert 15 comes into contact with the element 25 to be cooled or comes close to the element 25. In such an embodiment, it should be noted that the insert 15 may have a shape which is not circular, when seen from above (e.g. in a direction according to the axis X-X of Fig. 1). Such a shape may be a square or rectangular shape for instance.

In an example of an embodiment, the heat sink 10 is adjustably fitted into the body 11 by means of a first threaded part 13 of the insert 15 which engages a second threaded part 14 of the body 11. Preferably and as shown in the embodiments of Figs. 1, 2, 4 and 5, the first threaded part 13 is located at the periphery of the insert 15 and the second threaded part 14 is a threaded hole arranged within the body 11. In such a case, the periphery of the insert 15 presents a substantially circular shape and the insert 15 may have a generally cylindrical outer shape.

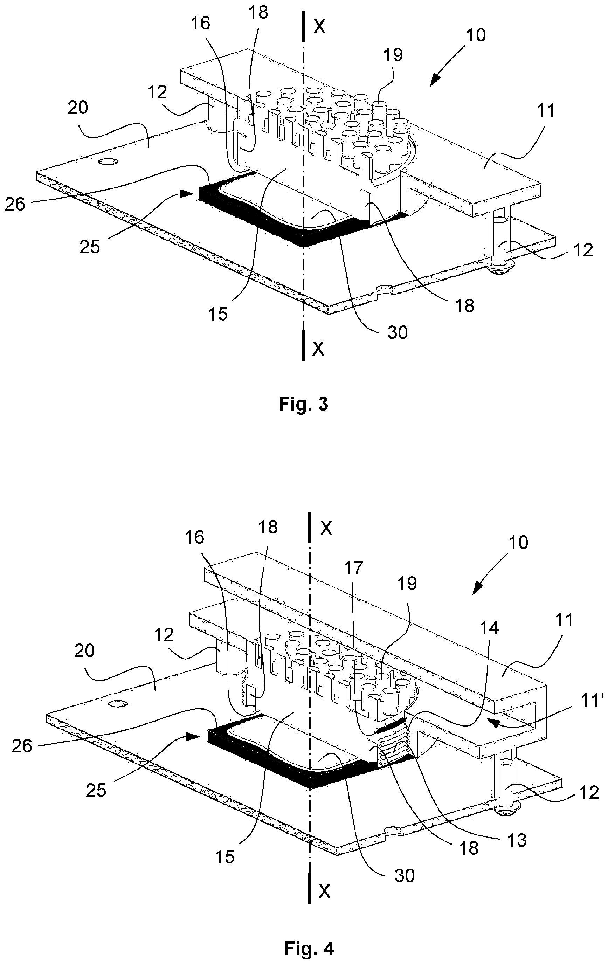

Fig. 3 depicts another embodiment in which the insert 15 is adjustably fitted into the body 11 by means of a push-fit inter-engagement. To this end, there is no threaded part at neither the outer periphery of the insert 15, nor at the inner surface of the hole or opening intended to host the insert 15, but both the outer periphery of the insert 15 and the aforementioned inner surface are sized to allow a push-fit inter-engagement, namely a press-fit connection in which there is preferably no play between the insert 15 and the body 11.

Still preferably and as also depicted in Fig. 3, the inter-engagement between the body 11 and the insert 15 involves the periphery of the insert 15 in its entirety. Such an embodiment ensures a very good heat transfer between the insert 15 and the body 11, thus allowing an efficient cooling of the element 25 to be cooled.

According to another embodiment, the heat sink 10 further includes a sealing 17 between the insert 15 and the body 11. Such a sealing 17 is shown in the embodiment depicted in Fig. 17 which is similar to that of Fig. 1 in the sense that it includes the aforementioned first and second threaded parts 13, 14. Preferably, the sealing 17 is part of the insert 15, as shown in Fig. 4. More specifically, the sealing 17 is preferably located above the first threaded part 13, namely at a location that is more distant from the insert contact surface 16 than the latter is from the first threaded part 13. In an alternative embodiment, the sealing 17 may be arranged in the body 11, more specifically within the inner surface of the hole or opening arranged in the body for receiving the insert 15, especially if the latter is adjustably fitted into the body 10 by means of a push-fit inter-engagement.

In one embodiment, the sealing 17 is a threaded sealant or a thread lock. Of course, such a sealing 17 is intended to be provided with one of the embodiments in which the insert 15 is adjustably fitted into the body 11 by means of the first and second threaded parts 13, 14.

According to another embodiment, the sealing 17 is an O-ring. Preferably, such an O-ring is intended to protrude at the periphery of the insert 15, as depicted in the example of Fig. 4. Whatever its embodiment, the sealing 17 may also prevent any accidental displacement of the insert 15 within the body 11 which may result from vibrations for example. Besides, the sealing 17 may be also used to meet ingress protection class requirements, especially against the ingress of dust and/or liquid, including cooling liquid that may be used in a cooling channel 11', as schematically depicted in the example of Fig. 4. Alternatively, a glue connection may be arranged between the insert 15 and the body 11, instead of the sealing 17 or in addition to the latter. Such a glue connection may also fixedly position the insert 15 within the body 11, once the insert 15 has been properly adjusted with respect to the contact surface 26 of the element 25 to be cooled.

In a further embodiment, the insert 15 is adjustably fitted into the body for coming into contact with the element 25 to be cooled via a first layer of a thermal interface material 30, as shown in the attached figures. The thermal interface material may be regarded as a gap filler which is mainly used to compensate some flatness defaults of the element contact surface 26 and/or some possible parallelism defects between the element contact surface 26 and the insert contact surface 16. In addition or instead of the above cited functions, the thermal interface material 30 could also play a gluing role for assembling the two aforementioned contact surfaces 16, 26. Anyway, due to its good thermal conductivity properties, the thermal interface material 30 helps to eliminate any remaining interstitial air gaps between the contact surfaces 16, 26 and helps to evacuate the heat emitted by the heating element 25. The thermal interface material 30 may typically consist of a gel, glue, a pad, an adhesive tape or thermal grease for example.

According to another embodiment, the insert 15 further includes a gripping means 18 that can be used for helping the insert 15 to be adjusted within the body 11. In the examples shown in Figs. 1 and 3-5, the gripping means 18 consists of a hole, especially a pair of holes having diametrically opposite locations with respect to the axis of rotation of the insert 15. The pair of holes allows inserting therein a tool, such as a wrench for example, which allows the insert 15 to be rotated or pushed so that it can be easily moved along its axis of movement X-X. In the embodiments shown as examples in the aforementioned figures, the pair of holes consists of blind holes open on the contact surface 16 of the insert 15. Alternatively, the gripping means 18 may be arranged on the surface opposite to the insert contact surface 16. In addition, the gripping means 18 may consist of any means for gripping the insert 15 by hand or with a tool. Therefore, the gripping means 18 may also consist of a projection extending from the surface opposite to the insert contact surface 16.

As shown in the figures, the insert 15 further includes a plurality of heat exchanger elements 19 arranged on the surface opposite to the insert contact surface 16. Because the surface onto which the heat exchanger elements 19 can take place is not intended to come into contact with the element 25 to be cooled, it may also referred to as a free surface of the insert 15. The heat exchanger elements 19 may consist of a plurality of pins, plates or fins extending away from the area where the heat originates. Preferably, the heat exchanger elements 19 extend above or beyond the body 11, as schematically shown in Figs. 1-3 and 5, or within a cooling channel 11' which may be part of the body, as depicted in Fig. 4.

Therefore and as shown in Fig. 4, the body 11 may further include, on a body free surface opposite to the element 25 to be cooled, at least one of:
- a plurality of heat exchanger elements 19, and
- at least one cooling channel 11' for transporting a fluid.

The fluid transported by the cooling channel 11' may be a gas or a liquid. The gas may be air or any other cooling gas, and the liquid may typically be water, oil or any other convenient liquid. The cooling channel 11' may be integrated within the body 11 of the heating sink 10 or may be attached to the body 11.

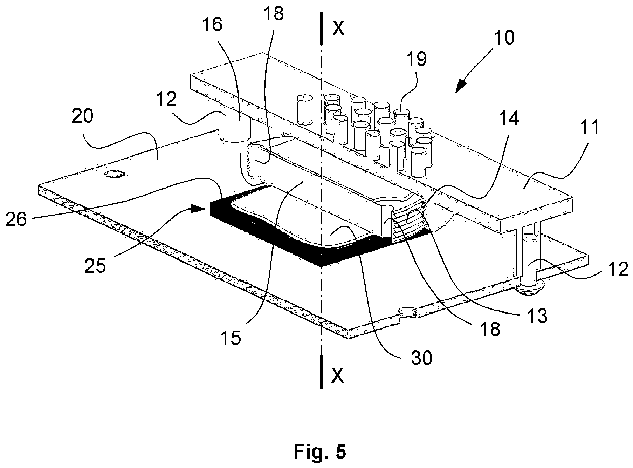

In the embodiment of Fig. 5, one can note that the heat exchanger elements 19 may be part of the body 11, in particular by extending in a direction away from the free surface of the body 11. As shown in Fig. 5, it should be also noted that the second threaded part 14 of the body 11 may consist of a blind threaded hole arranged within the body 11. In that case and as shown in Fig. 5, a second layer of a thermal interface material 30 may take place between the insert 15 and the body 11, in particular to increase the heat transfer between the insert 15 and the bottom of the blind threaded hole of the body 11.

The heat sink 10 may be made of any suitable thermal conductive material such as aluminum, copper or a combination of any materials for example. It should be also noted that the heat sink 10 may be obtain according to any possible combination of the features or the embodiments disclosed in the present description.

Simulations based on examples of the present heat sink 10 have shown that it is possible to obtain a significant temperature reduction of the element 25 to be cooled.

The present disclosure further relates to a printed circuit board as a support 20 non-adjustably mounted on a heat sink 10 according to any embodiment of the heat sink 10 or according to any possible combination of its embodiments.

As schematically depicted in Fig. 1, the present disclosure also relates to an ECU 40, in particular a vehicle ECU comprising a heat sink 10 according to any of its embodiments or according to any possible combination of its embodiments.

Finally, the present disclosure further relates to a vehicle 50, in particular a motor vehicle, comprising the ECU 40 or the aforementioned printed circuit board defined as the support 20 non-adjustably mounted on a heat sink 10, according to any embodiment of the heat sink 10 or according to any possible combination of its embodiments.

Although an overview of the inventive subject matter has been described with reference to specific example embodiments, various modifications and changes may be made to these embodiments without departing from the broader spirit and scope of embodiments of the disclosure disclosed in the present description.

## Claims

1. A heat sink (10) comprising a body (11) non-adjustably mountable on a support (20) provided with at least one element (25) to be cooled, **characterized in that** said body (11) comprises at least one insert (15) that is adjustably fitted therein so that an insert contact surface (16) comes into contact with the element (25) to be cooled.

2. The heat sink (10) of claim 1, wherein said insert (15) is adjustable along an axis of movement (X-X) that is perpendicular to an element contact surface (26) of the element to be cooled.

3. The heat sink (10) of claim 1 or 2, wherein the insert (15) is adjustably fitted into the body (11) by means of a first threaded part (13) of the insert (15) which engages a second threaded part (14) of the body (11).

4. The heat sink (10) of claim 3, wherein the first threaded part (13) is located at a periphery of the insert (15) and the second threaded part (14) is a threaded hole arranged within the body (11).

5. The heat sink (10) of claim 1 or 2, wherein the insert (15) is adjustably fitted into the body (11) by means of a push-fit inter-engagement.

6. The heat sink (10) of claim 5, wherein the inter-engagement between the body (11) and the insert (15) involves a periphery of the insert (15) in its entirety.

7. The heat sink (10) of any of claims 1 to 6, further comprising a sealing (17) between the insert (15) and the body (11).

8. The heat sink (10) of claim 7 and 3, wherein the sealing (17) is a thread sealant or a thread lock.

9. The heat sink (10) of claim 7, wherein the sealing (17) is an O-ring, preferably protruding at a periphery of the insert (15).

10. The heat sink (10) of any of claims 1 to 9, wherein the insert (15) is adjustably fitted into the body (11) for coming into contact with the element (25) to be cooled via a first layer of a thermal interface material (30).

11. The heat sink (10) of any of claims 1 to 10, wherein the insert (15) further comprises a gripping means (18) for helping the insert (15) to be adjusted within the body (11).

12. The heat sink (10) of any of claims 1 to 11, wherein the insert further comprises a plurality of heat exchanger elements (19) arranged on a free surface opposite to the insert contact surface (16).

13. The heat sink (10) of any of claims 1 to 12, wherein the body (11) further comprises, on a body free surface opposite to the element (25) to be cooled, at least one of a plurality of heat exchanger elements (19) and at least one cooling channel (11') for transporting a fluid.

14. A printed circuit board as a support (20) non-adjustably mounted on a heat sink (10) according to any of claims 1 to 13.

15. A vehicle (50) comprising a printed circuit board according to claim 14.
